(19)

Europäisches
Patentamt
European
Patent Office
Office européen
des brevets

(11)     **EP 2 284 552 B1**

(12)                          **EUROPEAN PATENT SPECIFICATION**

(45) Date of publication and mention
of the grant of the patent:
**10.10.2012  Bulletin 2012/41**

(51) Int Cl.:
**G01R 31/34** *(2006.01)*

(21) Application number: **10171035.8**

(22) Date of filing: **28.07.2010**

(54) **Method of inspecting linear motor condition**

Verfahren zur Prüfung des Zustands eines Linearmotors

Procédé d'inspection de la condition d'un moteur linéaire

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **29.07.2009  JP 2009177091**

(43) Date of publication of application:
**16.02.2011  Bulletin 2011/07**

(73) Proprietor: **Sanyo Denki Co., Ltd.
Tokyo (JP)**

(72) Inventor: **Takahashi, Akihiko
Tokyo (JP)**

(74) Representative: **Wilson Gunn
Blackfriars House
The Parsonage
5th Floor
Manchester M3 2JA (GB)**

(56) References cited:
**JP-A- 61 124 256     JP-A- 2002 267 727**

**Description**

TECHNICAL FIELD

The present invention relates to a method of inspecting a condition of a motor that generates a counter electromotive force or counter electromotive voltage when a mover of the motor is moved by an external force, and to a device for inspecting motor characteristics.

BACKGROUND ART

Japanese Patent Application Publication No. 2002-131153 (JP 2002-131153 A) discloses a torque measuring device for measuring a torque without using a torque meter. Japanese Patent Application Publication No. 61-124256 (JP 60-124256 A) discloses a method of measuring a thrust generated by a voice-coil linear motor by applying an external force for reciprocating a coil of the linear motor to calculate a thrust constant.

In existing motor condition inspection methods and motor characteristic inspecting devices, power is supplied to a motor to drive the motor at a constant rotational speed, and an output of the motor is measured to inspect characteristics of the motor such as a torque. Therefore, it is necessary to use, for example, a voltmeter, a tachometer, or a speed sensor for inspection to perform necessary measurement. Thus, in the related art, a motor installed in an apparatus is not directly inspected, and it is necessary to remove the motor from the apparatus and mount the motor on a dedicated inspecting device in order to inspect characteristics of the motor. Therefore, it is necessary to remove the motor from the apparatus for each regular checking or inspection, which consumes substantial labor and time required for the inspection. The installation condition of the motor cannot be inspected if the motor is removed from the apparatus.

For a linear motor, in particular, the installation condition of a mover and a stator (whether or not a so-called air gap is proper) affects an output of the motor. In the related art, a gap gauge is inserted into a gap formed between the mover and the stator to measure mechanical dimensions in order to inspect the installation condition. In this case, however, inspection is performed with the motor removed from the apparatus, and thus a mechanical error may likely occur when the motor is reinstalled in the apparatus after the inspection. Also, it is difficult to inspect whether or not the gap formed between the mover and the stator is totally uniform.

SUMMARY OF INVENTION

An object of the present invention is to provide a method of inspecting motor conditions and a device for inspecting motor characteristics allowing inspection of a motor installed in an apparatus without removing the motor from the apparatus.

Another object of the present invention is to provide a method of inspecting motor conditions and a device for inspecting motor characteristics allowing inspection as to whether or not a motor is properly installed in a convenient way.

The present invention is directed to a method of inspecting motor conditions and a device for inspecting motor characteristics allowing inspection of a condition of a motor installed in an apparatus without removing the motor from the apparatus, as defined in claim 1.

It is well known that a motor has a power generation function. Thus, when the mover of the motor is moved by an external force, a counter electromotive force or counter electromotive voltage is generated across terminals of the motor. In the present invention, a counter electromotive force constant $Ke\phi$, which is one of constants indicating characteristics of the motor, is computed to determine whether or not the characteristics of the motor are proper.

The counter electromotive force constant $Ke\phi$ is computed using the following formula:

$$Ke\phi \,=\, C \times (Ke/f)$$

where Ke is a peak value of the counter electromotive voltage in units of V, f is a frequency value of the counter electromotive voltage, and C is a constant. Thus, the counter electromotive force constant $Ke\phi$ can be calculated by measuring the peak and frequency values of the counter electromotive voltage. Accordingly, since the device for inspecting motor characteristics according to the present invention is intended to inspect a motor installed in an apparatus, an external force is applied, for example manually, to the mover of the motor when the motor is not driven and then is forcibly driven to generate a counter electromotive force. Because the external force is not constant, the counter electromotive force thus generated is represented by a waveform whose frequency is also not constant. There are various methods of acquiring a frequency from such a waveform. In the measuring section according to the present invention, for example, a zero crossing detecting circuit is utilized to measure the frequency by determining a period from a point at which the counter electromotive force waveform crosse a zero point to a point at which the counter electromotive force waveform crosses a next zero point as one cycle. Then, the counter electromotive force constant Keφ is calculated using an amplitude value of the waveform of which the frequency has been measured (a peak value of the counter electromotive voltage).

The result display section displays the computed result (a numerical value) for the counter electromotive force constant, which allows a measurer (a person who performs measurements) to determine whether or not the obtained counter electromotive force constant is proper for the motor. If the obtained counter electromotive force constant is not proper, it is found that the motor is in an abnormal state. The result display section may display a predetermined indication for an expected computed result of the counter electromotive force constant. This configuration facilitates determination as to whether or not the characteristics of the motor are proper even if it is not readily determined based on the counter electromotive force constant of the motor.

According to the present invention, any motor that generates a counter electromotive force may be inspected. Thus, any type of motor such as a linear motor, a servo motor, and a stepping motor may be inspected. If the motor to be inspected is a linear motor including a stator fixed to a stationary portion of an apparatus and a mover provided in a movable portion of the apparatus, the device for inspecting motor characteristics may further include an installation condition determining section for determining a size of a gap between a magnetic pole provided in the stator and a magnetic pole provided in the mover on the basis of the computed result to determine whether or not the motor is properly installed on the basis of the determined gap size. Because the gap size and the counter electromotive force constant are inversely proportional to each other, it is possible to know the gap size in the linear motor in the installed state utilizing such inversely proportional relationship, which allows determination as to the installation condition of the motor.

In general, the stator and the mover of a linear motor are separately formed, and assembled together at the location of use. That is, motor installation and gap adjustment is often performed by a user. Therefore, gap adjustment may not be adequately performed using a gap gauge, as a result of which a sufficient output of the linear motor may not be obtained. By using the device for inspecting motor characteristics according to the present invention, gap adjustment may be easily performed.

The installation condition determining section for a linear motor determines that the gap size exceeds an appropriate range if the counter electromotive force constant falls below a predetermined threshold range and that the gap size falls below the appropriate range if the counter electromotive force constant exceeds the predetermined threshold range, and then the installation condition determining section determines that the motor is not properly installed in either case. This configuration further facilitates gap adjustment.

BRIEF DESCRIPTION OF DRAWINGS

Fig. 1 shows an exemplary embodiment of a device for inspecting motor characteristics according to the present invention.
Fig. 2 is a block diagram showing the configuration of the embodiment of the present invention.
Fig. 3 is a flowchart showing an algorithm of software used to display a counter electromotive force constant and an indication for a computed result according to the embodiment of the present invention.
Fig. 4 shows a waveform of a counter electromotive force output when an external force is applied to a motor to drive the motor, according to the present invention.

DESCRIPTION OF EMBODIMENTS

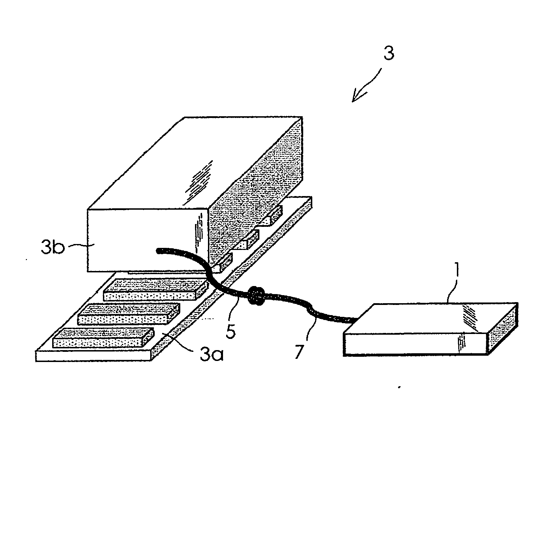

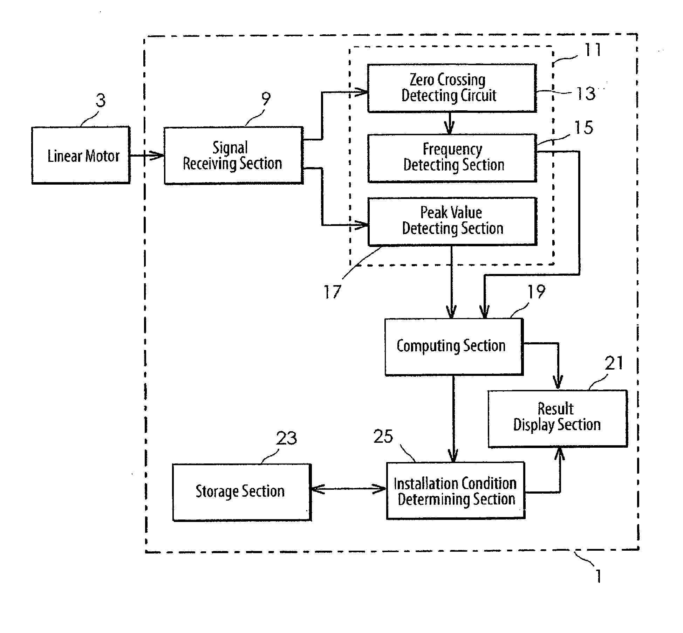

An embodiment of the present invention will now be described in detail below with reference to the accompanying drawings. Fig. 1 shows an exemplary embodiment of a device for inspecting motor characteristics according to the present invention. Fig. 2 is a block diagram showing the configuration of the embodiment of the present invention.

In the example embodiment shown in Fig. 1, a device for inspecting motor characteristics 1 is connected to a linear motor 3 to be inspected. The linear motor 3 includes a stator 3a fixed to a stationary portion of an apparatus and a mover 3b provided in a movable portion of the apparatus. The device for inspecting motor characteristics 1 is connected via a cable 7 to a power supply line 5 connected to a motor winding of the mover 3b of the linear motor 3 from which a power supply line has been disconnected.

The configuration and an overview of the embodiment of the present invention will be described with reference to Fig. 2. A signal receiving section 9 of the device for inspecting motor characteristics 1 receives a waveform of a counter electromotive force generated when the mover 3b of the linear motor 3 is moved by an external force. A measuring section 11 includes a zero crossing detecting circuit 13 and a frequency detecting circuit 15 for detecting a frequency of a voltage of the counter electromotive force, and further includes a peak value detecting circuit 17 for detecting a peak value of the voltage of the counter electromotive force. A computing section 19 computes a counter electromotive force constant on the basis of the frequency value and the voltage peak value detected by the measuring section 11 and then causes an indication for a computed result of the counter electromotive force constant to be displayed on a result display section 21. In the present invention, further, a storage section 23 stores a table for determining an installation condition of the linear motor 3, and an installation condition determining section 25 causes an indication for the determined installation condition on the basis of the computed result to be displayed on the result display section 21.

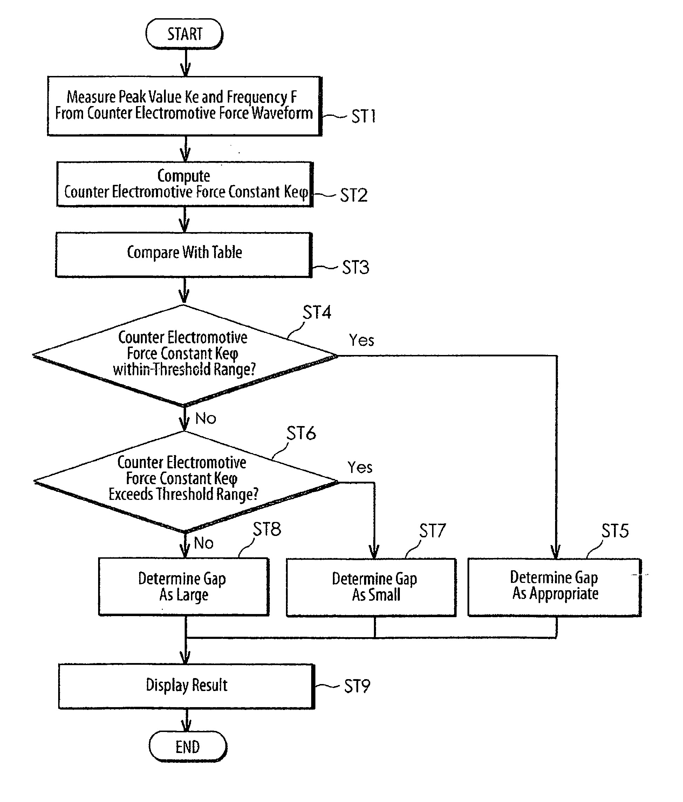

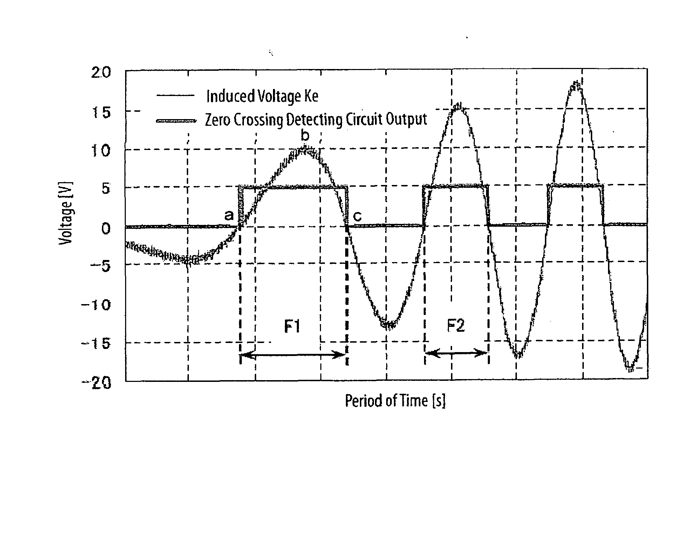

The flow from measurement to result display will be described in detail with reference to Figs. 3 and 4. When the mover 3b of the linear motor 3 is moved by an external force, the signal receiving section 9 receives a waveform of a counter electromotive force generated by the linear motor 3 as shown in Fig. 4, and sends a signal to the measuring section 11. The measuring section 11 measures a frequency value and a voltage peak value (in step ST1).

Specifically, the frequency value is determined as follows. When the mover of the motor is moved by an external force, the motor generates a counter electromotive force whose frequency and voltage peak values are not constant as shown in Fig. 4. The zero crossing detecting circuit 13 outputs a voltage whose value changes from 0 V to 5 V and from 5 V to 0 V at points where the counter electromotive force waveform crosses the value of zero (zero crossing points). When the counter electromotive force waveform of Fig. 4 is input, the zero crossing detecting circuit 13 outputs a-waveform of a zero crossing detection circuit output Vo of Pig. 4. On the counter electromotive force waveform of Fig. 4, for example, points a and c of the beginning waveform represent zero crossing points, and the frequency detecting circuit 15 detects a frequency f (= F1) for this portion from a cycle between the zero crossing points a and c.

Also, on the same beginning counter electromotive force waveform, the peak value detecting circuit 17 detects a point b as a peak value of the waveform.

Next, after receiving the detected frequency and peak values, the computing section 19 computes a counter electromotive force constant Ke$\phi$ (in step ST2) using the following formula:

$$\mathrm{Ke}\phi \ = \ C \times (\mathrm{Ke}/\mathrm{f}) \ \cdots \ (1)$$

where Ke is the peak value of the counter electromotive voltage in units of V, f is the frequency value of the counter electromotive voltage in units of Hz, and C is a constant.

The formula (1) is derived as follows.

If the motor is a linear motor, the counter electromotive force constant Ke$\phi$ can be calculated using the following formula:

$$\mathrm{Ke}\phi \ = \ \mathrm{Ke}/\mathrm{v} \ \cdots \ (2)$$

where Ke is the peak value of the counter electromotive voltage in units of V, and v is the velocity in units of m/s. Here, the following formula is satisfied:

$$\mathrm{v} \ = \ 2\tau \times \mathrm{f} \ \cdots \ (3)$$

where $\tau$ is the pole pitch which is the distance between magnets in units of m, and f is the frequency value of the counter electromotive voltage in units of Hz. Thus, the formula (3) is substituted into the formula (2) as follows:

$$\mathrm{Ke}\phi \ = \ \mathrm{Ke}/(2\tau \times \mathrm{f}) \ = \ (1/2\tau) \times (\mathrm{Ke}/\mathrm{f})$$

Here, when $1/2\tau$ is represented by C1, the following formula is obtained:

$$\mathrm{Ke}\phi \ = \ C1 \times (\mathrm{Ke}/\mathrm{f}) \ \cdots \ (4)$$

That is, in the case where the motor is a linear motor, the constant C in the formula (1) is obtained as C = C1 = $1/2\tau$.

In the case where the motor is a rotary motor, the counter electromotive force constant Ke$\phi$ can be calculated using the following formula:

EP 2 284 552 B1

$$Ke\phi = Ke/N \cdots (5)$$

where Ke is the peak value of the counter electromotive voltage in units of V, and N is the rotational speed in units of rpm. Here, the following formula is satisfied:

$$N = (120 \times f)/P \cdots (6)$$

where f is the frequency value of the counter electromotive voltage in units of Hz, and P is the number of poles. Thus, the formula (6) is substituted into the formula (5) as follows:

$$Ke\phi = Ke/(120 \times f)/P = (P/120) \times (Ke/f)$$

Here, when P/120 is represented by C2, the following formula is obtained:

$$Ke\phi = C2 \times (Ke/f) \cdots (7)$$

That is, in the case where the motor is a rotary motor, the constant C in the formula (1) is obtained as C = C2 = P/120.

After all, the counter electromotive force constant $Ke\phi$ can be derived through multiplication of the constant C if the counter electromotive voltage peak value Ke in units of V and the counter electromotive voltage frequency value f in units of Hz are measured. The counter electromotive force constant $Ke\phi$ can be computed using the formula (1) irrespective of the type of the motor, and can be calculated from the counter electromotive force waveform of Fig. 4 discussed earlier. While the constant C has been provided in advance in the computing section 19 in the embodiment, it is a matter of course that the constant C may be overwritten by an external device or an input section provided in the device of inspecting motor characteristics 1 for the purpose of generality.

Further in the present invention, the installation condition determining section 25 may determine the installation condition of the linear motor 3. The storage section 23 stores a table defining a size of a gap between a magnetic pole provided in the stator and a magnetic pole provided in the mover, and the computed counter electromotive force constant $Ke\phi$ is compared with the table (in step ST3). It is determined whether or not the counter electromotive force constant $Ke\phi$ falls within a certain threshold range (in step ST4). If the counter electromotive force constant $Ke\phi$ falls within the threshold range, it is determined that the gap size falls within an appropriate range (in step ST5). If the counter electromotive force constant $Ke\phi$ does not fall within the threshold range, it is determined whether or not the counter electromotive force constant $Ke\phi$ exceeds the threshold range (in step ST6). If the counter electromotive force constant $Ke\phi$ exceeds the threshold range, it is determined that the gap size falls below the appropriate range (in step ST7). If the counter electromotive force constant $Ke\phi$ falls below the threshold range, it is determined that the gap size exceeds the appropriate range (in step ST8). Finally, the result display section 21 displays an indication for the computed result including the counter electromotive force constant (in step ST9).

While the installation condition determining section 25 is provided to determine whether or not the gap size is proper in the embodiment, it is not necessary to provide the installation condition determining section 25 if it is only necessary to obtain the counter electromotive force constant $Ke\phi$. If a motor other than a linear motor is to be inspected, it is not necessary to make a determination as to a gap size. In this case, a general determining section may be provided in place of the installation condition determining section 25 so that the result display section 21 displays an indication that the motor is in a normal condition if the counter electromotive force constant $Ke\phi$ falls within the threshold range, and displays an indication that the motor is in an abnormal condition if the counter electromotive force constant $Ke\phi$ does not fall within the threshold range.

According to the present invention, characteristics of a motor may be inspected on the basis of a counter electromotive force waveform. Thus, the characteristics of the motor may be inspected without removing the motor from an apparatus and without the need for a tachometer or a speed sensor.

While certain features of the invention have been described with reference to example embodiments, the description is not intended to be construed in a limiting sense. Various modifications of the example embodiments, as well as other embodiments of the invention, which are apparent to persons skilled in the art to which the invention pertains are deemed to lie within the scope of the invention.

**Claims**

1. A method of inspecting a condition of a motor (3) installed in an apparatus without removing the motor from the apparatus, comprising:

   - preparing a device (1) for inspecting motor characteristics that comprises:

     a result display section (21) adapted to display a predetermined indication for a computed result or an expected computed result of the counter electromotive force constant (Ke$\phi$):

   - electrically connecting an armature winding of the motor (3) installed in the apparatus and the device (1) for inspecting motor characteristics with a power supply line disconnected from the motor(3);
   - applying an external force to the mover (3b) of the motor (3) to cause the armature winding to generate a counter electromotive force; and
   - determining whether or not the motor (3) is properly installed in the apparatus on the basis of the computed result displayed on the result display section (21) of the device for inspecting motor characteristics, wherein:

     the motor (3) is a linear motor comprising a stator (3a) being able to be fixed to a stationary portion of the apparatus and the mover (3b) provided in a movable portion of the apparatus;

     **characterized in that** the device (1) for inspecting motor characteristics further comprises a measuring section (11) adapted to measure a frequency value and an amplitude value of a waveform of a counter electromotive force generated when a mover (3b) of the motor (3) is moved by an external force;
     a computing section (19) adapted to compute a counter electromotive force constant on the basis of the frequency value and the amplitude value; and
     an installation condition determining section (25) adapted to determinine the size of a gap between a magnetic pole provided in the stator (3a) and a magnetic pole provided in the mover (3b) on the basis of the computed result to determine whether or not the motor (3) is properly installed on the basis of the determined gap size, and wherein:
     the installation condition determining section (25) is adapted to determine that the gap size exceeds an appropriate range if the counter electromotive force constant (Ke$\phi$) falls below a predetermined threshold range and that the gap size falls below the appropriate range if the counter electromotive force constant (Ke$\phi$) exceeds the predetermined threshold range;

   - adapted to and then the installation condition determining section (25) determines that the motor (3) is not properly installed in either case.

**Patentansprüche**

1. Verfahren zum Prüfen eines Zustands eines Motors (3), welcher in einer Vorrichtung installiert ist, ohne den Motor aus der Vorrichtung zu entnehmen, aufweisend:

   - Herrichten einer Einrichtung (1) zum Prüfen von Motorcharakteristika, welche aufweist:

     einen Ergebnisanzeigeabschnitt (21), welcher eingerichtet ist, eine vorbestimmte Angabe für ein berechnetes Ergebnis oder ein erwartetes, berechnetes Ergebnis der Konstante der gegenelektromotorischen Kraft (Ke$\phi$) anzuzeigen;

     - elektrisches Verbinden einer Ankerwicklung des Motors (3), welcher in der Vorrichtung installiert ist, und der Einrichtung (1) zum Prüfen der Motorcharakteristika mit einer Energieversorgungsleitung, welche von dem Motor (30) gelöst ist;
     - Aufbringen einer externen Kraft auf den Beweger (3b) des Motors (3), um zu bewirken, dass die Ankerwicklung eine gegenelektromotorische Kraft erzeugt; und
     - Bestimmen, ob oder ob nicht der Motor (3) richtig in der Vorrichtung installiert ist, auf der Basis des berechneten Ergebnisses, welches auf dem Ergebnisanzeigeabschnitt (21) der Einrichtung zum Prüfen der Motorcharakteristika angezeigt wird, wobei:

       der Motor (3) ein Linearmotor ist, welcher einen Stator (3a), welcher geeignet ist, an einem stationären Bereich der Vorrichtung befestigt zu sein, und den Beweger (3b) aufweist, welcher in einem bewegbaren Bereich der Vorrichtung vorgesehen ist;

**dadurch gekennzeichnet,**

**dass** die Einrichtung (1) zum Prüfen der Motorcharakteristika des Weiteren einen Messbereich (11) aufweist, welcher eingerichtet ist, einen Frequenzwert und einen Amplitudenwert einer Wellenform einer gegenelektromotorischen Kraft zu bestimmen, welche erzeugt wird, wenn ein Beweger (3b) des Motors (3) durch eine externe Kraft bewegt wird;

einen Berechnungsbereich (19), welcher eingerichtet ist, eine Konstante der gegenelektromotorischen Kraft auf der Basis des Frequenzwertes und des Amplitudenwertes zu berechnen; und

einen Installationszustandsbestimmungsbereich (25), welcher eingerichtet ist, die Größe einer Lücke zwischen einem Magnetpol, welcher in dem Stator (3a) vorgesehen ist, und einem Magnetpol, welcher in dem Beweger (3b) vorgesehen ist, auf der Basis des berechneten Ergebnisses zu bestimmen, um zu bestimmen, ob oder ob nicht der Motor (3) richtig installiert ist, auf der Basis der bestimmten Lückengröße, und wobei

der Installationszustandsbestimmungsbereich (25) eingerichtet ist, zu bestimmen, dass die Lücke einen geeigneten Bereich übersteigt, wenn die Konstante der gegenelektromotorischen Kraft (Keϕ) unter einen vorbestimmten Grenzbereich fällt, und dass die Lückengröße unter den geeigneten Bereich fällt, wenn die Konstante der gegenelektromotorischen Kraft (Keϕ) den vorbestimmten Grenzbereich überschreitet;

- und der Installationszustandsbestimmungsbereich (25) dann bestimmt, dass der Motor (3) in beiden Fällen nicht richtig installiert ist.

**Revendications**

1. Procédé destiné à inspecter l'état d'un moteur (3) installé dans un appareil sans retirer le moteur de l'appareil, comprenant les étapes consistant à :

- préparer un dispositif (1) destiné à inspecter des caractéristiques du moteur qui comprend :

une section d'affichage de résultat (21) adaptée pour afficher une indication prédéterminée pour un résultat calculé ou un résultat calculé attendu de la constante de force contre-électromotrice (Keϕ) ;

- raccorder électriquement un enroulement d'induit du moteur (3) installé dans l'appareil et le dispositif (1) pour inspecter des caractéristiques du moteur avec une ligne d'alimentation électrique déconnectée du moteur (3) ;
- appliquer une force extérieure à l'élément de déplacement (3b) du moteur (3) afin d'amener l'enroulement d'induit à générer une force contre-électromotrice ; et
- déterminer si oui ou non le moteur (3) est correctement installé dans l'appareil sur la base du résultat calculé affiché sur la section d'affichage de résultat (21) du dispositif destiné à inspecter des caractéristiques du moteur, dans lequel :

le moteur (3) est un moteur linéaire comprenant un stator (3a) qui peut être fixé sur une partie fixe de l'appareil et l'élément de déplacement (3b) disposé dans une partie mobile de l'appareil ;
**caractérisé en ce que** le dispositif (1) destiné à inspecter des caractéristiques du moteur comprend en outre une section de mesure (11) adaptée pour mesurer une valeur de fréquence et une valeur d'amplitude d'une forme d'onde d'une force contre-électromotrice générée lorsqu'un élément de déplacement (3b) du moteur (3) est déplacé par une force extérieure ;
une section de calcul (19) adaptée pour calculer une constante de force contre-électromotrice sur la base de la valeur de fréquence et de la valeur d'amplitude ; et
un section de détermination de l'état de l'installation (25) adaptée pour déterminer la taille d'un intervalle entre un pôle magnétique disposé dans le stator (3a) et un pôle magnétique disposé dans l'élément de déplacement (3b) sur la base du résultat calculé pour déterminer si oui ou non le moteur (3) est correctement installé sur la base de la taille de l'intervalle déterminée, et dans lequel :

la section de détermination de l'état de l'installation (25) est adaptée pour déterminer que la taille de l'intervalle dépasse une plage appropriée si la constante de force contre-électromotrice (Keϕ) tombe en dessous d'une plage de seuil prédéterminée, et que la taille de l'intervalle tombe en dessous de la plage appropriée si la constante de force contre-électromotrice (Keϕ) dépasse la plage de seuil prédéterminée ;

- et ensuite la section de détermination de l'état de l'installation (25) détermine que le moteur (3) n'est pas correctement installé dans un cas comme dans l'autre.

Flowchart:

START

Measure Peak Value Ke and Frequency F From Counter Electromotive Force Waveform — ST1

Compute Counter Electromotive Force Constant Keφ — ST2

Compare With Table — ST3

ST4: Counter Electromotive Force Constant Keφ within Threshold Range? — Yes → ST5 Determine Gap As Appropriate

No ↓

ST6: Counter Electromotive Force Constant Keφ Exceeds Threshold Range? — Yes → ST7 Determine Gap As Small

No ↓ ST8 Determine Gap As Large

Display Result — ST9

END

**EP 2 284 552 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002131153 A
- JP 61124256 A
- JP 60124256 A